(19) Europäisches Patentamt
European Patent Office
Office européen des brevets

(11) Publication number: 0 336 604 B1

# EUROPEAN PATENT SPECIFICATION

(45) Date of publication of patent specification: 08.02.95

(51) Int. Cl.⁶: C08G 8/04, G03F 7/00

(21) Application number: 89302864.7

(22) Date of filing: 22.03.89

(54) **Mixed aldehyde novolak resins and high contrast high thermal stability positive photoresists prepared therefrom.**

(30) Priority: 31.03.88 US 175473
22.04.88 US 297828
02.08.88 US 227404

(43) Date of publication of application:
11.10.89 Bulletin 89/41

(45) Publication of the grant of the patent:
08.02.95 Bulletin 95/06

(84) Designated Contracting States:
AT BE CH DE FR GB IT LI NL SE

(56) References cited:
EP-A- 0 083 971
EP-A- 0 211 667
EP-A- 0 227 487

(73) Proprietor: HOECHST CELANESE CORPORA-
TION
Route 202-206
Somerville, New Jersey 08876 (US)

(72) Inventor: Lazarus, Richard Michael
21775 Henrencia
Mission Viejo
California 92692 (US)
Inventor: Kautz, Randall William
4211 Belvedere
Irvine
California 92714 (US)
Inventor: Dixit, Sunit Suresh
23572 Via Breve
Mission Viejo
California 92691 (US)

(74) Representative: Bankes, Stephen Charles Dig-
by et al
BARON & WARREN
18 South End
Kensington
London W8 5BU (GB)

**Description**

The present invention relates to novolak resins, and, in particular, to novolak resins which are prepared using a mixture of aldehydes.

The present invention also relates to radiation-sensitive positive photoresist compositions and particularly to such compositions containing a novolak resin prepared from a mixture of aldehydes.

Positive photoresist formulations such as are described in, for example, U.S. Patents Nos. 3,666,473; 4,115,128; 4,173,470; 4,377,631; 4,536,465; and 4,529,682 include alkali-soluble phenol-formaldehyde or cresol-formaldehyde resins together with light-sensitive materials, usually a substituted naphthoquinone diazide compound. The resins and sensitizers are dissolved in an organic solvent or mixture of solvents and are applied in a thin film or coating to a substrate suitable for the particular application desired.

The novolak resin component of these photoresist formulations is soluble in alkaline aqueous solution, but the naphthoquinone sensitizer acts as a dissolution rate inhibitor with respect to the resin. Upon exposure of selected areas of the coated substrate to actinic radiation, however, the sensitizer undergoes a radiation-induced structural transformation which decreases its efficiency as a dissolution rate inhibitor for the novolak and, subsequently, the exposed areas of the coating are rendered more soluble than the unexposed areas. This difference in solubility rates causes the exposed areas of the photoresist coating to be dissolved when the substrate is immersed in alkaline developing solution while the unexposed areas are largely unaffected, thus producing a positive relief pattern of photoresist on the substrate.

Positive photoresists, especially those used to prepare microelectronic silicon wafers and chips, are often subjected to temperatures during the manufacture of the finished article which are high enough to have a deleterious effect on the photoresist. Thus, positive photoresists having improved thermal stability have long been sought. However, it is also very important that the photoresist be capable of providing high optical resolution so that precise patterns can be applied to the substrate. While positive photoresists having high resolution and contrast characteristics, such as DYNALITH® EPR-5000 resist sold by the Dynachem Division of Morton International, Inc., are known, and positive photoresists having good thermal stability, such as DYNALITH® OFPR-800 resist also sold by the Dynachem Division of Morton International, Inc., are also known, the art has yet to develop a positive photoresist which combines these thermal stability and high resolution and high contrast characteristics. In fact, formulation of a positive photoresist to enhance one of these characteristics normally adversely affects the other characteristic, i.e. photoresists with good thermal stability do not provide high resolution and high contrast and vice versa.

EP-A-0211667 discloses the preparation of a novolak resin for use in a photoresist by condensing a combination of m- and p-cresol with an aldehyde such as formaldehyde.

EP-A-0227487 discloses the preparation of a novolak resin by condensing an aldehyde with a polyhydroxybenzene such as resorcinol or pyrogallol alone or in combination with a monohydroxy benzene such as a cresol.

It has now been quite surprisingly found that positive photoresists having both a high degree of thermal stability and high resolution can be made when the novolak resin employed is prepared from a mixture of aldehydes comprising formaldehyde (or a formaldehyde precursor) and a monohydroxy aromatic aldehyde.

In accordance with the present invention, there is provided a novolak resin which is the condensation product of (a) a mixture of m- and p-cresol, and (b) an aldehyde component, characterised in that there is used as the aldehyde component a mixture of formaldehyde or formaldehyde precursor and an aromatic aldehyde selected from 2-hydroxybenzaldehyde, 3-hydroxybenzaldehyde, and 4-hydroxybenzaldehyde, in that the m- and p-cresol are present in the following amounts:

$$\frac{\text{moles m-cresol}}{\text{moles total cresol}} \times 100 = 30\% \text{ to } 75\%,$$

and in that the phenol and aldehyde components are present in the following amounts:

$$\frac{\text{moles total aldehyde}}{\text{moles total cresol}} \times 100 = 60\% \text{ to } 95\%$$

$$\frac{\text{moles aromatic aldehyde}}{\text{moles total aldehyde}} \times 100 = 15\% \text{ to } 95\%.$$

There is also provided in accordance with the present invention an improved positive photoresist comprising a novolak resin as defined above and a diazoquinone photosensitizer.

The present invention also provides a method of forming a resist pattern on a substrate comprising:

I. coating said substrate with a layer of a positive photoresist composition as defined above;

II. exposing said layer patternwise to actinic radiation; and

III. removing the exposed portion of said layer with an aqueous alkaline developer for the exposed resist composition to uncover the areas of the substrate beneath the exposed portions.

In accordance with the present invention, there is also provided a substrate coated with a thermally stable and highly resolved, exposed resist pattern, said resist pattern being formed from a positive photoresist composition which, prior to exposure to actinic radiation, is as defined above.

The mixed aldehydes useful in preparing the novolak resins of the present invention contain formaldehyde or a formaldehyde precursor. As used herein, "formaldehyde precursor" refers to compounds, such as 1,3,5-S-trioxane and paraformaldehyde which, under the reaction conditions employed to prepare the novolak resin will produce formaldehyde. As used herein, the term "formaldehyde" is selected from 2-hydroxybenzaldehyde, 3-hydroxybenzaldehyde, and 4-hydroxybenzaldehyde. Mixtures of these aromatic aldehydes may be used. These monohydroxybenzaldehydes produce novolak resin which may be used to make high resolution, high thermal stability positive photoresists.

The relative amounts of the cresols and mixed aldehydes used to prepare to novolak resins of the present invention are chosen to produce novolak resins having high melting points (Tg), high degree of substitution at the bridging carbons and relatively low molecular weights (compared to novolak resins prepared from formaldehyde only).

Given the above reactants and their relative amounts, one of ordinary skill in the art would be capable of preparing the novolak resins of the present invention without undue experimentation. Basically, all of the ingredients are placed in a suitable reaction vessel and a nonreactive solvent added. An acid catalyst, such as p-toluenesulfonic acid, is added in a mole ratio of moles catalyst/moles total cresol of about 0.01 to about 0.04. The reaction mixture is then raised to reflux temperature and reflux maintained until no more by-product water is produced, indicating that the reaction is complete.

The novolak resins of the present invention are especially useful in positive photoresist formulations. These formulations typically contain a novolak resin, a sensitizer (or "photoactive component"), solvent and various additives such as colorants, striation aids, and the like. In commercial positive photoresists, the novolak resin is most commonly a cresol-formaldehyde novolak and the photoactive component is a diazo quinone compound. Examples of diazo quinone compounds include 2,3,4-trihydroxybenzophenone-1, 2-napthoquinonediazide-5-sulfonic acid mono-, di-, and triesters and 2,3,4-trihydroxybenzophenone-1,2-naphthoquinone -2-diazo-4-sulfonic acid mono-, di-, and triesters. Examples of these and other diazo sensitizers may be found in U.S. Patent No. 4,499,171 issued February 12, 1985 to Hosaka et al. Examples of solvents include propylene glycol monomethyl ether acetate (PMA), ethyl cellosolve acetate, ethyl 3-ethoxy propionate, diglyme, butyrolactone, xylene, and butyl acetate.

The critical components of the positive resist formulation, namely, the novolak resin of the present invention and the photoactive component, can be employed over a wide range of relative amounts. In general, it is necessary only that sufficient photoactive component be employed to produce a resist which is photoimagable and that the amount of novolak resin be bindingly effective. In terms of relative amounts, the positive photoresists of this invention may contain from 2 parts by weight (pbw) novolak resin per pbw photoactive component to 6 pbw novolak resin per pbw photoactive component. Preferably, a ratio of about 4 pbw novolak resin per pbw photoactive component is employed.

The amount of solvent in the resist may likewise vary considerably. Generally, all that is required is that sufficient solvent be employed to produce a desired coating thickness under the given coating conditions, e.g. spin speed and pre-bake temperature. Typically, however, enough solvent is added to the positive photoresist formulation to produce a photoresist having 25-30% solids.

The positive resists of this invention may also contain various additives such as colorants, striation aids, and the like. Also, the novolak resin component of the resist may be comprised entirely of the novolak resins of the present invention, or may contain up to 35 weight percent (based on the total weight of the resin component of the resist) of a conventional novolak resin, such as a cresol/formaldehyde novolak resin prepared using a mixture of 65-70% m-cresol and 30-35% p-cresol.

Positive resists formulated with the novolak resins of the present invention which are prepared from the preferred monohydroxybenzaldehydes have relatively high thermal stability. For example, resists which employ the formaldehyde/monohydroxybenzaldehyde mixture are stable for at least 30 minutes in a conventional oven at temperatures of 200-220°C whereas the aforementioned DYNALITH® EPR-5000 resist is stable only to about 140°C and DYNALITH® OFPR-800 resist is stable only to about 180°C when baked

3

for about 30 minutes in a conventional oven.

The following examples illustrate the present invention:

EXAMPLE 1

This example illustrates a typical procedure for making the novolak resins of the present invention. The following reagents were used in the amounts indicated:

| REAGENT | AMOUNT |
|---|---|
| m-cresol | 125.9 g |
| p-cresol | 103.0 g |
| o-hydroxybenzaldehyde (98%) | 123.6 g |
| trioxane | 30.1 g |
| Isopropyl acetate | 313.5 g |
| p-toluenesulfonic acid • $H_2O$ catalyst | 4.0 g |

All of the ingredients, except the catalyst, were combined in a suitable reaction vessel. The catalyst was then added and the resulting reaction mixture was heated at reflux temperature. Reflux was continued until no more by-product water was produced, which indicated completion of the reaction. The resulting novolak resin was then recovered.

EXAMPLES 2 - 30

Novolak resins in accordance with this invention were prepared in a manner similar to that of Example 1 using the reagents indicated in Table I below.

## TABLE I

| Ex. No. | Cresol A | Cresol B | Ald. 1 | Ald. 2 | Cat. | $^1R_c$ | $^2R_f$ | $^3R_a$ | $^4R_h$ | $^5R_w$ | $^\circ C$ | Hr. |
|---|---|---|---|---|---|---|---|---|---|---|---|---|
| 2 | m-cresol | p-cresol | Formald | 4HB[6] | pTSA[7] | 0.349 | 0.645 | 0.188 | 0.025 | 1.55 | 95-120 | 27 |
| 3 | m-cresol | p-cresol | Formald | 4HB | pTSA | 0.350 | 0.640 | 0.500 | 0.025 | 0.95 | 95-120 | 24 |
| 4 | m-cresol | p-cresol | Formald | 4HB | pTSA | 0.350 | 0.700 | 0.500 | 0.040 | 1.04 | 95-120 | 15 |
| 5 | m-cresol | p-cresol | Formald | 4HB | pTSA | 0.450 | 0.700 | 0.500 | 0.040 | 1.04 | 95-120 | 16 |
| 6 | m-cresol | p-cresol | Formald | 4HB | pTSA | 0.450 | 0.760 | 0.500 | 0.040 | 1.04 | 95-120 | 16 |
| 7 | m-cresol | p-cresol | Formald | 4HB | pTSA | 0.550 | 0.700 | 0.490 | 0.040 | 1.04 | 95-120 | 16 |
| 8 | m-cresol | p-cresol | Formald | 4HB | pTSA | 0.550 | 0.760 | 0.486 | 0.040 | 1.13 | 95-120 | 15 |
| 9 | m-cresol | p-cresol | Formald | 4HB | pTSA | 0.550 | 0.810 | 0.500 | 0.040 | 1.20 | 95-120 | 15 |
| 10 | m-cresol | p-cresol | Formald | 4HB | pTSA | 0.647 | 0.705 | 0.497 | 0.032 | 1.04 | 95-120 | 16 |
| 11 | m-cresol | p-cresol | Formald | 4HB | pTSA | 0.650 | 0.760 | 0.500 | 0.040 | 1.13 | 95-120 | 15 |
| 12 | m-cresol | p-cresol | Formald | 2HB[8] | pTSA | 0.350 | 0.666 | 0.508 | 0.025 | 0.960 | 95-120 | 17 |

[1] $R_c$ = moles m-cresol/total moles cresol
[2] $R_f$ = total moles aldehyde/total moles cresol
[3] $R_a$ = moles Aldehyde 2/total moles aldehyde
[4] $R_h$ = moles catalyst/total moles cresol
[5] $R_w$ = moles water/total moles cresol
[6] 4HB = 4-hydroxybenzaldehyde
[7] pTSA = p-toluenesulfonic acid
[8] 2HB = 2-hydroxybenzaldehyde
[9] Benz = benzaldehyde

EP 0 336 604 B1

## TABLE I (continued)

| Ex. No. | Cresol A | Cresol B | Ald. 1 | Ald. 2 | Cat. | $^1$Rc | $^2$Rf | $^3$Ra | $^4$Rh | $^5$Rw | °C | Hr. |
|---|---|---|---|---|---|---|---|---|---|---|---|---|
| 13 | m-cresol | p-cresol | Formald | 2HB | pTSA | 0.350 | 0.747 | 0.500 | 0.040 | 1.180 | 95-120 | 15 |
| 14 | m-cresol | p-cresol | Formald | 2HB | pTSA | 0.449 | 0.698 | 0.500 | 0.040 | 1.040 | 95-120 | 16 |
| 15 | m-cresol | p-cresol | Formald | 2HB | pTSA | 0.450 | 0.764 | 0.500 | 0.040 | 1.130 | 95-120 | 14 |
| 16 | m-cresol | p-cresol | Formald | 2HB | pTSA | 0.550 | 0.708 | 0.549 | 0.040 | 1.040 | 95-120 | 15 |
| 17 | m-cresol | p-cresol | Formald | 2HB | pTSA | 0.550 | 0.767 | 0.491 | 0.040 | 1.130 | 95-120 | 15 |
| 18 | m-cresol | p-cresol | Triox$^9$ | 2HB | pTSA | 0.550 | 0.756 | 0.503 | 0.020 | 0.248 | 85-95 | 15 |
| 19 | m-cresol | p-cresol | Triox | 2HB | pTSA | 0.550 | 0.784 | 0.498 | 0.015 | 0.020 | 110-115 | 11 |
| 20 | m-cresol | p-cresol | Triox | 2HB | pTSA | 0.550 | 0.788 0.812 | 0.502 0.502 | 0.020 | 0.264 | 100-105 | 10 20 28 |
| 21 | m-cresol | p-cresol | Triox | 2HB | pTSA | 0.550 | 0.856 | 0.502 | 0.010 | 0.533 | 100-105 | 28 |
| 22 | m-cresol | p-cresol | Triox | 2HB | pTSA | 0.550 | 0.950 | 0.500 | 0.010 | 0.535 | 100-105 | 24 |

| | | |
|---|---|---|
| $^1$Rc | = | moles m-cresol/total moles cresol |
| $^2$Rf | = | total moles aldehyde/total moles cresol |
| $^3$Ra | = | moles aldehyde 2/total moles aldehyde |
| $^4$Rh | = | moles catalyst/total moles cresol |
| $^5$Rw | = | moles water/total moles cresol |
| $^6$4HB | = | 4-hydroxybenzaldehyde |
| $^7$pTSA | = | p-toluenesulfonic acid |
| $^8$2HB | = | 2-hydroxybenzaldehyde |
| $^9$Benz | = | benzaldehyde |

EP 0 336 604 B1

TABLE I (continued)

| Ex. No. | Cresol A | Cresol B | Ald. 1 | Ald. 2 | Cat. | $^1Rc$ | $^2Rf$ | $^3Ra$ | $^4Rh$ | $^5Rw$ | °C | Hr. |
|---|---|---|---|---|---|---|---|---|---|---|---|---|
| 23 | m-cresol | p-cresol | Triox | 2HB | pTSA | 0.551 | 0.379 0.766 | 1.000 0.506 | 0.010 | 0.010 | 110-135 | 10 20 |
| 24 | m-cresol | p-cresol | Triox | 2HB | pTSA | 0.550 | 0.427 0.854 | 1.000 0.502 | 0.010 | 0.535 | 100-105 | 14 28 |
| 25 | m-cresol | p-cresol | Triox | 2HB | pTSA | 0.547 | 0.423 0.846 | 1.000 0.499 | 0.010 | 0.010 | 100-135 | 11 22 |
| 26 | m-cresol | p-cresol | Triox | 2HB | pTSA | 0.548 | 0.944 | 0.495 | 0.010 | 0.010 | 115-120 | 18 |
| 27 | m-cresol | p-cresol | Triox | 2HB | pTSA | 0.550 | 0.900 | 0.250 | 0.010 | 0.010 | 115-120 | 19 |
| 28 | m-cresol | p-cresol | Triox | 2HB | pTSA | 0.550 | 0.900 | 0.500 | 0.010 | 0.010 | 115-120 | 19 |
| 29 | m-cresol | p-cresol | Triox | 2HB | pTSA | 0.550 | 0.900 | 0.750 | 0.010 | 0.010 | --- | 19 |
| 30 (Ref) | m-cresol | p-cresol | Formald | Benz$^9$ | pTSA | 0.55 | 0.9 | 0.75 | 0.01 | 0.01 | --- | --- |

$^1Rc$ = moles m-cresol/total moles cresol

$^2Rf$ = total moles aldehyde/total moles cresol

$^3Ra$ = moles aldehyde 2/total moles aldehyde

$^4Rh$ = moles catalyst/total moles cresol

$^5Rw$ = moles water/total moles cresol

$^6$4HB = 4-hydroxybenzaldehyde

$^7$pTSA = p-toluenesulfonic acid

$^8$2HB = 2-hydroxybenzaldehyde

$^9$Benz = benzaldehyde

COMPARATIVE EXAMPLES A - J

For comparative purposes, novolak resins prepared from a single aldehyde were made using a procedure similar to that of Example 1 and the reagents shown in Table A.

TABLE A

| Ex. No. | Cresol A | Cresol B | Ald. 1 | Ald. 2 | Cat. | Rc | Rf | Ra | Rh | Rw | °C | Hr. |
|---|---|---|---|---|---|---|---|---|---|---|---|---|
| A | m-cresol | p-cresol | - | Benzald | pTSA | 0.354 | 0.631 | 1.000 | 0.036 | 0.04 | 100-120 | 4 |
| B | m-cresol | p-cresol | - | 2ClBenzald[a] | pTSA | 0.354 | 0.640 | 1.000 | 0.039 | 0.04 | 95-110 | 4 |
| C | m-cresol | p-cresol | - | 4HB | pTSA | 0.354 | 0.640 | 1.000 | 0.040 | 0.04 | 100-130 | 4 |
| D | m-cresol | p-cresol | - | 4HB | pTSA | 0.354 | 0.640 | 1.000 | 0.040 | 0.04 | 100-130 | 4 |
| E | m-cresol | p-cresol | - | 4HB | pTSA | 0.350 | 0.810 | 1.000 | 0.039 | 0.04 | 100-105 | 2 |
| F | m-cresol | p-cresol | - | 4HB | pTSA | 0.749 | 0.637 | 1.000 | 0.039 | 0.04 | 95-105 | 13 |
| G | m-cresol | p-cresol | - | 4HB | pTSA | 0.750 | 0.805 | 1.000 | 0.039 | 0.04 | 100-105 | 2 |
| H | m-cresol | p-cresol | - | 2HB | pTSA | 0.354 | 0.639 | 1.000 | 0.040 | 0.04 | 100-120 | 7 |
| I | m-cresol | p-cresol | - | 2HB | pTSA | 0.350 | 0.750 | 1.000 | 0.040 | 0.04 | 100-105 | 8 |
| J | m-cresol | p-cresol | - | Piperonal | pTSA | 0.350 | 0.375 | 1.000 | 0.040 | 0.04 | 100-120 | 16 |

[a] 2ClBenzald = 2-chlorobenzaldehyde

EXAMPLES 31 - 54 AND COMPARATIVE EXAMPLES K - T

The novolak resins prepared in the foregoing examples were used to formulate positive photoresists. The photoresist was prepared by simply blending the ingredients shown in Table II below in the amounts

indicated.

## TABLE II

| Ex. No. | Novolak 1 from Ex. No./Amnt.[a] | Novolak 2[b]/Amnt. | Amnt. PAC[c] | Amnt., PMA | Other |
|---|---|---|---|---|---|
| 31 | 2/13.89 | 7.48 | 5.33 | 73.00 | 0.28 |
| 32 | 3/13.89 | 7.48 | 5.33 | 73.00 | 0.28 |
| 33 | 4/14.05 | 7.55 | 5.39 | 72.72 | 0.28 |
| 34 | 5/14.05 | 7.57 | 5.40 | 72.69 | 0.28 |
| 35 | 7/14.09 | 7.58 | 5.41 | 72.62 | 0.28 |
| 36 | 8/13.89 | 7.48 | 5.33 | 73.00 | 0.28 |
| 37 | 9/14.02 | 7.55 | 5.39 | 72.72 | 0.28 |
| 38 | 10/14.05 | 7.55 | 5.39 | 72.72 | 0.28 |
| 39 | 11/14.05 | 7.55 | 5.39 | 72.72 | 0.28 |
| 40 | 12/14.04 | 7.55 | 5.39 | 72.72 | 0.28 |
| 41 | 13/14.04 | 7.55 | 5.39 | 72.72 | 0.28 |
| 42 | 14/13.89 | 7.48 | 5.34 | 72.99 | 0.28 |
| 43 | 15/13.89 | 7.48 | 5.34 | 73.00 | 0.27 |
| 44 | 16/13.48 | 7.19 | 6.17 | 72.87 | 0.27 |
| 45 | 17/16.80 | 8.96 | 7.69 | 66.26 | 0.29 |
| 46 | 22/11.92 | 6.35 | 5.45 | 76.65 | 0.26 |
| 47 | 23/14.04 | 7.54 | 5.39 | 72.74 | 0.28 |

a  All amounts are weight percent based on total weight.
b  Novolak 2 is a low molecular weight cresol/formaldehyde novolak.
c  PAC = photoactive component.

TABLE II (continued)

| Ex. No. | Novolak 1 from Ex. No./Amnt. | Novolak 2/Amnt. | Amnt. PAC[c] | Amnt. PMA | Other |
|---|---|---|---|---|---|
| 48 | 24/12.48 | 6.66 | 5.71 | 74.88 | 0.26 |
| 49 | 25/14.04 | 7.54 | 5.39 | 72.73 | 0.28 |
| 50 | 26/14.04 | 7.54 | 5.39 | 72.73 | 0.28 |
| 51 | 27/14.04 | 7.55 | 5.39 | 72.75 | 0.28 |
| 52 | 28/14.04 | 7.55 | 5.39 | 72.74 | 0.28 |
| 53 | 29/14.04 | 7.55 | 5.39 | 72.75 | 0.28 |
| 54 (Ref) | 30/21.69 | 11.67 | 8.33 | 57.6 | 0.74 |
| K | A/14.00 | 7.53 | 5.38 | 72.83 | 0.28 |
| L | B/13.87 | 7.47 | 5.34 | 73.04 | 0.28 |
| M | C/13.87 | 7.47 | 5.33 | 73.05 | 0.28 |
| N | D/13.87 | 7.47 | 5.33 | 73.03 | 0.28 |
| O | E/14.01 | 7.54 | 5.39 | 72.78 | 0.28 |
| P | F/13.87 | 7.47 | 5.39 | 73.04 | 0.28 |
| Q | G/14.01 | 7.54 | 5.39 | 72.77 | 0.28 |
| R | H/13.99 | 7.54 | 5.39 | 72.80 | 0.28 |
| S | I/14.03 | 7.56 | 5.39 | 72.73 | 0.28 |
| T | J/14.03 | 7.56 | 5.39 | 72.73 | 0.28 |

The following examples illustrate the performance of the positive photoresist formulations of Examples 31-54 and Comparative Examples K-T.

EXAMPLES 55 - 78 AND COMPARATIVE EXAMPLES U - DD

Each, in turn, of the resist compositions of Examples 31-54 and Comparative Examples K-T was spin coated on a track coater manufactured by Silicon Valley Group, California, onto thermally-grown silicon/silicon dioxide coated wafers of 4 inch diameter and 5000 Angstrom oxide thickness. A uniform coating of 1.0 $\mu$m of resist film was obtained at a spinning velocity of 3,500 revolutions per minute. The coated wafers were then soft baked either in an air circulating oven at 120°C for 30 minutes or on a track with hot plate at 110°C for 60 seconds. The resist film thickness was then measured with a Nanospec AFT thickness measuring tool.

The coated wafers were exposed with an Ultratech® ultrastep 1000 (1:1) projection stepper fitted with a lens of N.A. 0.325 to provide ultraviolet exposure radiation in the range of 390 nm-450 nm. A Micromask® mask with line and space widths of varying sizes, including some as small as 0.75 $\mu$m; was used to provide a selective exposure pattern. Exposure times were varied in order to determine the photospeed of the resist, i.e., the minimum amount of exposure energy (intensity x time) in millijoules/cm$^2$ which will solubilize the exposed areas of the resist so that the resist in the exposed areas will be completely removed/cleared during development.

The exposed resist coated wafers produced as described above were placed in Teflon wafer boats and either immersed in a one-gallon Teflon container containing DYNALITH® NMD-3 developer, which is an aqueous alkaline solution stabilized at about 19°C± 1°C, or processed on a track developing equipment manufactured by Silicon Valley Group, California. The wafers were allowed to remain immersed in the developer solution for 60 seconds. Upon removal from the developer, the wafers were rinsed in deionized water and dried by a burst of nitrogen gas or by placing them in a spin dryer. Following development, the wafers were examined with an optical microscope at a "1000X" magnification.

Post-baking of the developed wafers was done in an air circulating oven at about 150°C, 280°C, or 200°C for 30 minutes to increase the adhesion and chemical resistance of the undissolved portions of the coatings. Post-bake flow of the images were examined by an optical microscope at "1000X" magnification.

The results of these performance tests are shown in Table III below:

TABLE III

| Ex. No. | Resist from Ex. No. | Photospeed mJ/cm² | Developer | Dev. Time (Seconds) | ZFL[d] | Residue[e] | Bridges[f] | Side Wall[g] |
|---|---|---|---|---|---|---|---|---|
| 55 | 31 | >100 | 0.1N DE-3[h] | 60 | 0.47 | 0 | 2.00 | +1 |
| (Control)[i] | | (85) | (0.2N DE-3) | (240) | (0.34) | (0) | (1.50) | - |
| 56 | 32 | 75 | 0.1N DE-3 | 60 | 1.28 | 0 | 0.75 | 0 |
| (Control) | | (85) | (0.2N DE-3) | (240) | (0.34) | (0) | (1.50) | - |
| 57 | 33 | 56 | 9.2N DE-3 | 60 | 0.00 | 0 | 0.75 | - |
| (Control) | | (68) | (0.2N DE-3) | (240) | (0) | (0) | (1.25) | - |
| 58 | 34 | 80 | 0.1N DE-3 | 60 | - | 0 | 1.00 | 0 |
| | | 30 | 0.2N DE-3 | 30 | 18.04 | 0 | 1.00 | - |
| (Control) | | (65) | (0.3N DE-3) | (60) | (0.48) | (0) | (1.50) | - |
| 59 | 35 | 105 | 0.2N DE-3 | 30 | 1.07 | 0 | 0.75 | -1 |
| (Control) | | (65) | (0.3N DE-3) | (60) | (0.48) | (0) | (1.50) | - |
| 60 | 36 | 95 | 0.1N DE-3 | 60 | 1.67 | 0 | 0.75 | +1 |
| (Control) | | (85) | (0.2N DE-3) | (240) | (0.34) | (0) | (1.50) | - |

d   ZFL = percent film loss in unexposed areas
e   Residue is measured on a 0-10 scale, 0 being no residue; 10 being full coverage of 1 micron lines and spaces
f   Bridges = largest geometry bridged (microns)
g   Side wall parameter qualifies as more (+1), same as (0), or less (-1) vertical compared to the control
h   DE-3 = DYNALITH® developer sold by the Dynachem Division of Morton Thiokol, Inc.
i   All control tests were performed with DYNALITH® EPR-5000 positive photoresist sold by the Dynachem Division of Morton Thiokol, Inc.

12

EP 0 336 604 B1

## TABLE III (continued)

| Ex. No. | Resist from Ex. No. | Photospeed mj/cm$^2$ | Developer | Dev. Time (Seconds) | %FL | Residue | Bridges | Side Wall |
|---------|---------------------|----------------------|-----------|---------------------|-----|---------|---------|-----------|
| 61 (Control) | 37 | 70 (80) | 0.1N DE-3 (0.2N DE-3) | 60 (240) | 3.34 (0) | 0 (0) | 0.75 (1.50) | - - |
| 62 (Control) | 38 | 45 (68) | 0.2N DE-3 (0.2N DE-3) | 60 (240) | 4.33 (0) | 0 (0) | 0.75 (1.25) | - - |
| 63 (Control) | 39 | 30 (80) | 0.1N DE-3 (0.2N DE-3) | 60 (240) | 18.01 (0) | 0 (0) | 0.75 (1.50) | - - |
| 64 (Control) | 40 | 40 (155) | 0.2N DE-3 (0.2N DE-3) | 30 (60) | 3.81 (0) | 0 (0) | 1.00 (1.5) | - - |
| 65 (Control) | 41 | 70 (65) | (0.2N DE-3) (0.3N DE-3) | 30 (60) | 2.6 (0.48) | 0 (0) | 0.80 (1.5) | - - |
| 66 (Control) | 42 | 38 (139) | 0.2N DE-3 (0.2N DE-3) | 30 (30) | 9.72 (0) | 0 (0) | 1.00 (1.5) | - - |
| 67 (Control) | 43 | 38 (139) | 0.2N DE-3 (0.2N DE-3) | 30 (30) | 5.81 (0) | 0 (0) | 1.00 (1.5) | - - |
| 68 (Control) | 44 | 55 (155) | 0.2N DE-3 (0.2N DE-3) | 30 (60) | 4.65 (0) | 0 (0) | 0.80 (1.5) | - - |
| 69 (Control) | 45 | 60 (155) | 0.2N DE-3 (0.2N DE-3) | 30 (60) | 3.84 (0) | 0 (0) | 0.80 (1.5) | - - |
| 70 (Control) | 46 | 35 (145) | 0.2N DE-3 (0.2N DE-3) | 30 (60) | 5.80 (0.21) | 0 (0) | 1.00 (1.5) | -1 (0) |

TABLE III (continued)

| Ex. No. | Resist from Ex. No. | Photospeed mj/cm$^2$ | Developer | Dev. Time (Seconds) | %FL | Residue | Bridges | Side Wall |
|---|---|---|---|---|---|---|---|---|
| 71 (Control) | 47 | >300 (155) | 0.2N DE-3 (0.2N DE-3) | 60 (60) | 1.00 (0) | 10 (0) | unmeas. (1.5) | - - |
| 72 (Control) | 48 | 45 (145) | 0.2N DE-3 (0.2N DE-3) | 30 (60) | 0 (0.21) | 0 (0) | 1.00 (1.5) | -1 (0) |
| 73 (Control) | 49 | >270 (155) | 0.2N DE-3 (0.2N DE-3) | 60 (60) | 1.50 (0) | 10 (0) | unmeas. (1.5) | - - |
| 74 (Control | 50 | 185 (155) | 0.2N DE-3 (0.2N DE-3) | 60 (60) | 0 (0) | 0 (0) | >0.8 (1.5) | 0 (0) |
| 75 | 51 | 245 | 0.2N DE-3 | 60 | 0.35 | 0 | 1.00 | - |
| 76 | 52 | 165 | 0.2N DE-3 | 60 | 0.52 | 0 | 0.80 | - |
| 77 (Control) | 53 | 70 (155) | 0.2N DE-3 (0.2N DE-3) | 60 (60) | 0.23 (0.07) | 0 (0) | <0.80 (1.50) | - - |
| 78 (Ref) (Control) | 54 | 300 (125) | 1.0N DE-3 (0.2N DE-3) | 60 (60) | 2.13 (0) | 1.0 (0) | 2.0 (1.5) | - - |
| U | K | >600 | 2.70 NMD3[J] | 480 | 0.00 | - | - | - |
| V | L | >600 | 2.70 NMD3 | 480 | 0.00 | - | - | - |

[J]  2.70 NMD3= 2.70% tetramethylammonium hydroxide in water

EP 0 336 604 B1

EP 0 336 604 B1

TABLE III (continued)

| Ex. No. | Resist from Ex. No. | Developer | Photospeed mj/cm² | Dev. Time (Seconds) | %FL | Residue | Bridges | Side Wall |
|---|---|---|---|---|---|---|---|---|
| W |  | 0.62 TMAH[k] | 100 | 180 | 4.78 | - | - | +1 |
|  |  | Dev. A[l] | 110 | 30 | 2.01 | 9 | 0.75 | +1 |
|  |  | 0.2N DE-3 | 40 | 60 | 11.12 | 8 | 0.75 | · |
| X |  | 0.62 TMAH | 100 | 180 | 6.66 | 10 | 0.75 | +1 |
|  |  | Dev. A | 110 | 30 | 4.01 | 9 | 0.75 | +1 |
|  |  | 0.2N DE-3 | 40 | 60 | 10.68 | 8 | 0.75 | 0 |
| (Control) |  | (2.40 TMAH) | (55) | (180) | (1.00) | (0) | (1.50) | - |
| (Control) |  | (0.2N DE-3) | (85) | (240) | (0.60) | (0) | (1.50) | - |
| Y |  | 0.1N DE-3 | 40 | 60 | 14.54 | 5 | 1.75 | - |
| (Control) |  | (0.2N DE-3) | (107) | (120) | (0) | (0) | (1.50) | - |
| Z |  | 0.6N DE-3 | 75 | 60 | 3.54 | 0 | 0.75 | -1 |
| (Control) |  | (0.6N DE-3) | (>110) | (60) | (0) | (0) | (1.25) | - |
| AA |  | 0.1N DE-3 | 73 | 60 | 10.29 | 3 | 0.75 | - |
| (Control) |  | (0.2N DE-3) | (107) | (120) | (0) | (0) | (1.50) | - |
| BB |  | 0.2N DE-3 | 50 | 60 | 10.49 | 0 | 0.75 | - |
| (Control) |  | (0.2N DE-3) | (107) | (120) | (0) | (0) | (1.25) | - |
| CC |  | 0.2N DE-3 | 78 | 60 | 1.17 | 0 | 0.75 | - |
| (Control) |  | (0.2N DE-3) | (68) | (240) | (0) | (0) | (1.25) | - |
| DD |  | 0.2N DE-3 | 50 | 60 | 6.35 | 0 | 1.00 | - |
| (Control) |  | (0.2N DE-3) | (69) | (240) | - | (0) | (1.50) | - |

k  0.62 TMAH = 0.62% tetramethylammonium hydroxide in water
l  Dev. A = High contrast developer

## Claims

1. A novolak resin which is the condensation product of (a) a mixture of m- and p-cresol, and (b) an aldehyde component, characterised in that there is used as the aldehyde component a mixture of formaldehyde or formaldehyde precursor and an aromatic aldehyde selected from 2-hydroxybenzaldehyde, 3-hydroxybenzaldehyde, and 4-hydroxybenzaldehyde, in that the m- and p-cresol are present

EP 0 336 604 B1

in the following amounts:

$$\frac{\text{moles m-cresol}}{\text{moles total cresol}} \times 100 = 30\% \text{ to } 75\%,$$

and in that the phenol and aldehyde components are present in the following amounts:

$$\frac{\text{moles total aldehyde}}{\text{moles total cresol}} \times 100 = 60\% \text{ to } 95\%$$

$$\frac{\text{moles aromatic aldehyde}}{\text{moles total aldehyde}} \times 100 = 15\% \text{ to } 95\%.$$

2. A positive photoresist composition comprising:
   A. a novolak resin according to claim 1 and
   B. a diazoquinone photosensitizer.

3. A positive photoresist composition according to Claim 2 wherein the photosensitizer is a naphthoquinone diazide sensitizer.

4. A positive photoresist composition according to Claim 3 wherein the naphthoquinone diazide sensitizer is selected from esters of 1,2-naphthoquinone-2-diazo-4-sulfonic acid and esters of 1,2-naphthoquinone-2-diazo-5-sulfonic acid.

5. A positive photoresist composition according to Claim 4 wherein the naphthoquinone diazide sensitizer is selected from
   2,3,4-trihydroxybenzophenone-1,2-naphthoquinone-2-diazo-4-sulfonic acid monoester; 2,3,4-trihydroxybenzophenone-1 2-naphthoquinone-2-diazo-4-sulfonic acid diester; 2,3,4-trihydroxybenzophenone-1,2-naphthoquinone-2-diazo-4-sulfonic acid triester and mixtures thereof.

6. A positive photoresist composition according to Claim 4 wherein the naphthoquinone diazide sensitizer is selected from
   2,3,4-trihydroxybenzophenone-1,2-naphthoquinone-2-diazo-5-sulfonic acid monoester;
   2,3,4-trihydroxybenzophenone-1,2-naphthoquinone-2-diazo-5-sulfonic acid diester; 2,3,4-trihydroxybenzophenone-1,2-naphthoquinone-2-diazo-5-sulfonic acid triester and mixtures thereof.

7. A positive photoresist composition according to any one of Claims 2 to 6, comprising from 2 to 6 parts by weight of said novolak resin to 1 part by weight of diazoquinone sensitizer.

8. A method of forming a resist pattern on a substrate comprising:
   I. coating said substrate with a layer of a positive photoresist composition according to any one of Claims 2 to 7;
   II. exposing said layer patternwise to actinic radiation; and
   III. removing the exposed portion of said layer with an aqueous alkaline developer for the exposed resist composition to uncover the areas of the substrate beneath the exposed portions.

9. A substrate coated with a thermally stable and highly resolved, exposed resist pattern, said resist pattern being formed from a positive photoresist composition which, prior to exposure to actinic radiation, is as claimed in any one of Claims 2 to 7.

**Patentansprüche**

1. Novolak-Harz, das das Kondenstionsprodukt ist von (a) einer Mischung von m- und p-Kresol und (b) einer Aldehydkomponente, dadurch gekennzeichnet, daß für die Aldehydkomponente eine Mischung von Formaldehyd oder ein Vorgänger davon und ein aromatisches Aldehyd, ausgewählt aus 2-

16

Hydroxybenzaldehyd, 3-Hydroxybenzaldehyd, 4-Hydroxybenzaldehyd verwendet wird, daß die m- und p-Kresole in folgenden Mengen vorkommen:

Mole m-Kresol / Gesamtmole der Kresolmole * 100 = 30% - 75% und daß die Phenol- und Aldehydkomponenten in folgenden Mengen vorkommen:

Gesamtmole der Aldehyde / Gesamtmole der Kresole * 100 = 60% - 95%

Mole der aromatischen Aldehyde / Gesamtmole der Aldehyde * 100 = 15% - 95%

2. Positive photoresistente Zusammensetzung, die umfaßt:
   A) ein Novolak-Harz nach Anspruch 1, und
   B) einen Diazoquinon-Photosensitizer.

3. Positive photoresistente Zusammensetzung nach Anspruch 2, wobei der Photosensitizer ein Naphtoquinon-Diazid-Photosensitizer ist.

4. Positive photoresistente Zusammensetzung nach Anspruch 3, wobei der Naphtoquinon-Diazid-Photosensitizer ausgewählt ist von Estern von 1,2- Naphtoquinon-2-Diazo-4-Sulfoniksäure und von Estern von 1,2- Naphtoquinon-2-Diazo-5-Sulfoniksäure.

5. Positive photoresistente Zusammensetzung nach Anspruch 4, wobei der Naphtoquinon-Diazid-Photosensitizer ausgewählt ist aus
   2,3,4-Trihydroxybenzophenon-1,2- Naphtoquinon-2-diazo-4-Sulfoniksäuremonoester; 2,3,4-Trihydroxybenzophenon-1,2- Naphtoquinon-2-diazo-4-Sulfoniksäurediester; 2,3,4-Trihydroxybenzophenon-1,2-Naphtoquinon-2-diazo-4-Sulfoniksäuretriester und Mischungen davon.

6. Positive photoresistente Zusammensetzung nach Anspruch 4, wobei der Naphtoquinon - Diazid -Photosensitizer ausgewählt ist aus 2,3,4-Trihydroxybenzophenon-1,2- Naphtoquinon-2-diazo-5-Sulfoniksäuremonoester; 2,3,4-Trihydroxybenzophenon-1,2- Naphtoquinon-2-diazo-5-Sulfoniksäurediester; 2,3,4-Trihydroxybenzophenon-1,2- Naphtoquinon-2-diazo-5-Sulfoniksäuretriester und Mischungen davon.

7. Positive photoresistente Zusammensetzung nach einem der Ansprüche 2 - 6, die zwei bis sechs Gewichtsanteile dieses Novolak-Harzes und einen Gewichtsanteil des Diazoquinonsensitizers enthält.

8. Verfahren zum Ausbilden eines resistenten Musters auf einem Substrat vor, das umfaßt:
   I. Beschichten dieses Substrats mit einer Schicht aus einer positive photoresistenten Komponente nach einem der Ansprüche 2-7,
   II. Aussetzen dieser Schicht musterweise unter aktinische Strahlung, und
   III. Entfernen des bestrahlten Bereichs dieser Schicht mit einem wässrigen alkalischen Entwickler für die bestrahlte resistente Komponente, um die Bereiche des Substrats unterhalb der bestrahlten Bereiche freizulegen.

9. Substrat, das mit einem thermisch stabilen und hochauflösenden, bestrahlten resistenten Muster beschichtet ist, wobei dieses resistente Muster hergestellt ist aus einer positiven photoresistenten Zusammensetzung, die vor dem Aussetzen unter aktinische Strahlung beschaffen ist wie in einem der Ansprüche 2 - 7.

**Revendications**

1. Résine novolaque qui est le produit de condensation de (a) un mélange de m-crésol et p-crésol et (b) un composant du type aldéhyde, caractérisée en ce qu'un mélange de formaldéhyde ou d'un précurseur de formaldéhyde et d'un aldéhyde aromatique choisi parmi le 2-hydroxybenzaldéhyde, le 3-hydroxybenzaldéhyde et le 4-hydroxybenzaldéhyde est utilisé comme composant de type aldéhyde, en ce que le m-crésol et le p-crésol sont présents dans les proportions suivantes :

/(moles m-crésol)/(moles crésol total)/ x 100 = 30% à 75%

et en ce que les composants du type phénol et du type aldéhyde sont présents dans les proportions suivantes :

/(moles aldéhyde total)/(moles crésol total)/ x 100 = 60% à 95%

/(moles aldéhyde aromatique)/(moles aldéhyde total)/ x 100 = 15% à 95%.

2. Composition de photorésist positif comprenant :
   A. une résine novolaque selon la revendication 1 et
   B. un agent de sensibilisation du type diazoquinone.

3. Composition de photorésist positif selon la revendication 2, dans laquelle l'agent de sensibilisation est un agent de sensibilisation du type naphtoquinone diazide.

4. Composition de photorésist positif selon la revendication 3, dans laquelle l'agent de sensibilisation du type naphtoquinone diazide est choisi parmi les esters de l'acide 1,2-naphtoquinone-2-diazo-4-sulfonique et les esters de l'acide 1,2-naphtoquinone-2-diazo-5-sulfonique.

5. Composition de photorésist positif selon la revendication 4, dans laquelle l'agent de sensibilisation du type naphtoquinone diazide est choisi parmi un monoester de l'acide 2,3,4-trihydroxybenzophénone-1,2-naphtoquinone-2-diazo-4-sulfonique, un diester de l'acide 2,3,4-trihydroxybenzophénone-1,2-naphtoquinone-2-diazo-4-sulfonique, un triester de l'acide 2,3,4-trihydroxybenzophénone-1,2-naphtoquinone-2-diazo-4-sulfonique et des mélanges de ceux-ci.

6. Composition de photorésist positif selon la revendication 4, dans laquelle l'agent de sensibilisation du type naphtoquinone diazide est choisi parmi un monoester de l'acide 2,3,4-trihydroxybenzophénone-1,2-naphtoquinone-2-diazo-5-sulfonique, un diester de l'acide 2,3,4-trihydroxybenzophénone-1,2-naphtoquinone-2-diazo-5-sulfonique, un triester de l'acide 2,3,4-trihydroxybenzophénone-1,2-naphtoquinone-2-diazo-5-sulfonique et des mélanges de ceux-ci.

7. Composition de photorésist positif selon l'une quelconque des revendications 2 à 6, comprenant de 2 à 6 parties en poids de ladite résine novolaque pour 1 partie en poids d'agent de sensibilisation du type diazoquinone.

8. Procédé, permettant de former un motif de photorésist sur un substrat, qui consiste :
   I. à revêtir le substrat d'une couche d'une composition de photorésist positif selon l'une quelconque des revendications 2 à 7,
   II. à exposer la couche à un rayonnement actinique d'une manière conforme à un motif et
   III à éliminer la partie exposée de la couche au moyen d'un agent de développement basique aqueux associé à la composition de photorésist exposée, de façon à découvrir les zones du substrat situées au-dessous des parties exposées.

9. Substrat revêtu d'un motif de photorésist exposé qui est thermiquement stable et présente une haute résolution, le motif de photorésist étant formé d'une composition de photorésist positif qui, avant exposition au rayonnement actinique, est telle que définie à l'une quelconque des revendications 2 à 7.